(19) Europäisches Patentamt

European Patent Office

Office européen des brevets

(11) Veröffentlichungsnummer: **0 436 876 A2**

(12) **EUROPÄISCHE PATENTANMELDUNG**

(21) Anmeldenummer: **90124442.6**

(22) Anmeldetag: **17.12.90**

(51) Int. Cl.⁵: **H03K 19/086**

(30) Priorität: **11.01.90 DE 4000665**

(43) Veröffentlichungstag der Anmeldung:
**17.07.91 Patentblatt 91/29**

(84) Benannte Vertragsstaaten:
**DE FR GB IT NL**

(71) Anmelder: **Siemens Aktiengesellschaft**
**Wittelsbacherplatz 2**
**W-8000 München 2(DE)**

(72) Erfinder: **Barré, Claude, Dipl.-Ing.**
**Impler Strasse 23**
**W-8000 München 70(DE)**

(54) **Integrierbare Transistorschaltstufe der Logik-Familie NTL.**

㊐ Die bekannten Schaltungsanordnungen in NTL-Technik arbeiten zwar ebenso schnell, wie Gatter, die in ECL-Technik aufgebaut sind, weisen aber eine in der Praxis kaum nutzbare Übertragungskennlinie auf. Gemäß der vorliegenden Erfindung wird die Übertragungskennlinie der in NTL-Technik ausgeführten Gatter durch Einfügen von MOS-Transistoren (TS2, TS3) so verändert, daß sie den jeweiligen Erfordernissen einer Logikschaltungsanordnung, auch in Kombination mit anderen Logikschaltungsfamilien genügt.

**FIG 3**

EP 0 436 876 A2

## INTEGRIERBARE TRANSISTORSCHALTSTUFE DER LOGIK-FAMILIE NTL

Die Erfindung betrifft eine integrierbare Transistorschaltstufe gemäß dem Oberbegriff des Patentanspruchs 1.

Die schnellsten gebräuchlichen Logikschaltungen - auf Siliziumsubstrat - arbeiten derzeit in ECL-Technik (Emitter-Coupled-Logic). Bei dieser Technik macht man sich die günstigen Eigenschaften von Bipolartransistoren zunutze, die mit Strömen und Spannungen unterhalb der Sättigungsgrenze betrieben werden. Typisches Merkmal dieser Logikfamilie ist die Verbindung zweier Bipolartransistoren an ihren Emittern. Die Basis eines dieser Transistoren dient als Eingang des Grundgatters, während die Basis des anderen Transistors mit einer konstanten Spannung beaufschlagt wird. Der Wert dieser Spannung liegt zwischen den für die logischen Zustände High und Low festgelegten Spannungswerten. Dadurch ist ein sicheres Umschalten des Spannungswertes am Ausgang bei definierten Spannungswerten am Eingang eines ECL-Gatters gewährleistet. Das Umschalten erfolgt durch Sperren des bisher leitenden und Leitendmachen des bisher gesperrten Transistors. Da die beiden Transistoren mit ihren Emittern aber verbunden sind, ist der Summenstrom beider Emitterstrompfade stets konstant und ungleich Null. In jedem logischen Zustand wird also Leistung verbraucht.

Eine Logikfamilie, die ebenso schnell wie die ECL-Technik arbeitet, aber nur in einem der beiden möglichen logischen Zustände Leistung verbraucht, ist die Logikfamilie in NTL-Technik (Non Threshold Logic). Das Grundgatter dieser Logikfamilie besteht gemäß der Literaturstelle Rein/Ranfft: "Integrierte Bipolarschaltungen", Springer-Verlag, 1987, S. 191 aus einem Bipolartransistor mit einem Kollektor- und einem Emitterwiderstand. Zwischen Kollektor und Emitter der Schaltung liegt eine konstante Versorgungsspannung. Die Basis des Transistors dient als Gattereingang und der Kollektor als Gatterausgang. Die am Transistor liegenden Spannungen sind so gewählt, daß der Transistor - wie bei der ECL-Technik - niemals in Sättigung gerät. Die logischen Zustände am Gatterausgang werden durch das Durchschalten oder Sperren des Transistors und damit des Strompfades erreicht. Statistisch betrachtet halbiert sich der Leistungsbedarf bei der NTL-Technik gegenüber der ECL-Technik, wodurch ein gravierender Vorteil bezüglich des Leistungsverbrauchs gegeben ist. Zwei Gründe sprechen aber dennoch gegen eine Verwendung der NTL-Technik. Es sind keine komplementären Gatterausgänge wie bei der ECL-Technik vorhanden und die Übertragungskennlinie der NTL-Gatter weist keine definierte Schaltschwelle und keine in jedem logischen Zustand konstante, von der Eingangsspannung unabhängige Ausgangsspannung auf. Eine definierte Schaltschwelle und konstante logische Spannungspegel sind aber Grundvoraussetzung dafür, eine störungssichere Logikschaltung zu realisieren.

Um Logikschaltungen der NTL-Familie in der Praxis anwendbar zu machen, werden deshalb Maßnahmen getroffen, die die negativen Eigenschaften der NTL-Schaltkreise beherrschbar machen. Eine mögliche schaltungstechnische Maßnahme ist die Variation dar emitterseitigen Spannung entsprechend den Eigenschaften des Schalttransistors. Die Übertragungskennlinie des Transistors wird durch Regelung einer veränderbaren, aber konstanten Versorgungsspannung so beeinflußt, daß der Verlauf der Übertragungskennlinie ein Optimum erreicht. Das erreichbare Optimum gewährleistet aber lediglich, daß die Abhängigkeit der Ausgangsspannung von der Eingangsspannung eines Gatters vorbestimmbar und damit handhabbar ist. Eine Sicherheit der Schaltfunktionen, die mit der aus der ECL-Technik bekannten Sicherheit vergleichbar ist, erreicht man jedoch nicht. Die Methode, den einmal festgelegten Emitterwiderstand konstant zu halten, aber die Versorgungsspannung am Emitterstrompfad des Bipolartransistors zu variieren, birgt den Nachteil, daß für die veränderbare aber konstante Versorgungsspannung eine aufwendige Regelschaltung erforderlich ist, da die Spannungsquelle einen relativ hohen Strom an den niederohmigen Schaltungseingang liefern muß.

Die der Erfindung zugrundeliegende Aufgabe besteht darin, Logikschaltungen der NTL-Familie derart auszugestalten, daß die bei der ECL-Technik gegebene Schaltsicherheit auch für die NTL-Technik geschaffen wird.

Diese Aufgabe wird ausgehend von der im Oberbegriff des Patentanspruchs 1 definierten integrierbaren Transistorschaltung durch die Merkmale des kennzeichnenden Teils gelöst.

Als wesentlich für die Erfindung ist anzusehen, daß der Emitterwiderstand durch die Drain-Source-Strecke eines MOS-Transistors ersetzt wird. Auch eine Reihen- oder Parallelschaltung von Widerständen und MOS-Transistoren anstelle des Emitterwiderstandes ist denkbar. Maßgeblich ist, daß der Gesamtwiderstand der den Emitterwiderstand ersetzenden oder ergänzenden Bauelemente so veränderbar ist, daß die Kennlinie des Bipolartransistors in geeigneter Weise beeinflußbar ist. Wird nämlich der Emitterwiderstand verkleinert, so wechselt bei einem Wechsel des logischen Zustands am Eingang der Ausgangsspannungspegel schneller den logischen Zustand; die Übertragungskennlinie wird also steiler. Der Grund dafür ist, daß im Schaltzeitpunkt bei einem kleineren Emitterwiderstand ein größerer Strom in der Kollektor-Emitter-Strecke des Bipolartransistors unter der Voraussetzung fließen kann, daß die Spannungen, mit denen der Transistor betrieben wird, konstant bleiben.

Nutzt man die günstigen Eigenschaften des MOS-Transistors - hochohmiger Gate-Eingang und Widerstandsänderung bei Spannungsänderung der Gate-Source-Strecke - in Kombination mit einer konstanten Versorgungsspannung am Emitterstrompfad des Bipolartransistors, so läßt sich der Strom durch die Kollektor-Emitter-Strecke des Bipolartransistors durch Verändern der Eingangsspannung am MOS-Transistor - und damit Verändern des Emitterwiderstandes - so beeinflussen, daß die Übertragungskennlinie des Gatters bei einem definierten Spannungspegel am Eingang einen steilen Verlauf in Richtung des dem am Ausgang bestehenden logischen Zustand entgegengesetzten logischen Zustands am Ausgang aufweist. Die veränderbare Spannungsquelle braucht wegen des hochohmigen Gate-Eingangswiderstandes kaum mehr Strom zu liefern und ist deshalb in einfacher Weise realisierbar. Eine On-Chip-Lösung, die gleichzeit eine Vielzahl von MOS-Transistoreingängen auf dem Chip bedienen kann, ist möglich.

Damit sind die Möglichkeiten, die das Betreiben des NTL-Gatters mit konstanten Versorgungsspannungen bietet, noch nicht ausgeschöpft. Durch das Einfügen von weiteren Bauelementen in den Emitterstrompfad kann unabhängig von der ersten Beeinflussungsmöglichkeit der Eigenschaften der Transistorschaltung eine weitere Beeinflussungsmöglichkeit vorgesehen werden. So wird durch Einbringen von Bauelementen - vorzugsweise eines MOS-Transistors - der Strom im Kollektor-Emitterstrompfad begrenzt. Ein in den Emitterstrompfad mit seiner Drain-Source-Strecke eingefügter MOS-Transistor wird mit einer dritten konstanten Spannung an seinem Gate-Anschluß beaufschlagt, wobei die Höhe der Gate-Source-Spannung den Wert des maximalen Stroms bestimmt, der in der Drain-Source-Strecke des MOS-Transistors und damit im Kollektor-Emitterstrompfad des Bipolartransistors fließen kann. Mit dieser Strombegrenzung wird auch der Strom durch den Kollektorwiderstand begrenzt und damit die Spannung, die an diesem Widerstand abfällt. Der Ausgang des Logikgatters liegt zwischen dem Kollektor des Bipolartransistors und dem Kollektorwiderstand. Ist der Spannungsabfall am Kollektorwiderstand begrenzt, so ist die minimale Ausgangsspannung des Gatters ebenso begrenzt. Damit können also zwei definierte, von der Basiseingangsspannung des Bipolartransistors in relativ weiten Bereichen unabhängige Ausgangsspannungspegel in einem NTL-Gatter realisiert werden. Bei gesperrtem Bipolartransistor ist der Ausgangsspannungspegel gleich dem Pegel der ersten konstanten Versorgungsspannung, bei leitendem Bipolartransistor entspricht der Ausgangsspannungspegel der konstanten ersten Versorgungsspannung abzüglich des - durch die Strombegrenzung bewirkten - maximalen Spannungsabfalls am Kollektorwiderstand.

Durch das Einbringen einer den Strom im Kollektor-Emitterpfad des Bipolartransistors begrenzenden Einheit und eines veränderbaren Widerstandes im gleichen Strompfad wird also die Möglichkeit geschaffen, die Übertragungskennlinie des NTL-Gatters in weiten Grenzen frei zu bestimmen. Insbesondere ist eine Angleichung der NTL-Übertragungskennlinie an die Übertragungskennlinie von Gattern der ECL-Technik möglich, d.h., daß die NTL-Technik nun beherrschbar ist, einen ebensogroßen Störabstand hat, wie er bei ECL-Technik üblich ist und eine bisher notwendige direkte Kopplung der Entwicklung der Schaltungslogik mit der Entwicklung der Schaltungstechnik entfällt. Es besteht vielmehr die Möglichkeit, auf einem einzigen Chip ohne Signalanpassung wahlweise Gatter in ECL-Technik und in NTL-Technik in beliebiger Folge zusammenzuschalten, je nachdem welche Erfordernisse an das Gatter gestellt werden. Sind komplementäre Ausgänge eines Gatters nicht erforderlich, so wird man vorzugsweise statt des ECL-Gatters ein Gatter der NTL-Technik aufgrund der erzielbaren Leistungsminimierung wählen. Ein Nachteil bezüglich der Schaltzeiten entsteht dabei nicht, da die MOS-Transistoren nicht am Schaltprozeß des Gatters beteiligt sind, sondern ausschließlich zur Einstellung der Übertragungskennlinie und damit der Eigenschaften des Gatters dienen.

Eine zusätzliche Möglichkeit, die Übertragungskennlinie des NTL-Gatters zu optimieren, besteht darin, einen Grundlaststrompfad von der zweiten konstanten Spannungsquelle über die sich im Emitterstrompfad befindenden MOS-Transistoren - an Bipolartransistor und Kollektorwiderstand vorbei - über einen ohmschen Widerstand zur ersten konstanten Spannungsquelle zu schalten. Der ohmsche Widerstand muß aber nicht unmittelbar an der ersten konstanten Versorgungsspannung angeschlossen werden, sondern muß lediglich mit einem Potential verbunden sein, das soweit über der zweiten konstanten Versorgungsspannung liegt, daß durch die MOS-Transistoren im Emitterzweig ein permanenter Strom fließt, der in der Größenordnung von 1% des Stromes liegt, der bei durchgeschaltetem Bipolartransistor in der Kollektor-Emitterstrecke fließt. Man erreicht mit dieser Maßnahme einen noch exakteren Schaltpunkt des Gatters. Eine Abflachung der Übertragungskurve des NTL-Gatters im Bereich des Schaltpunktes infolge des allmählichenDrain-Source-Stromanstiegs bei

Erhöhung der Gate-Source-Spannung wird also vermieden.

Die Verstärkung eines Bipolartransistors in Emitterschaltung kann bekanntermaßen durch eine Kapazität parallel zum Emitterwiderstand aufgrund der Verringerung des Grades der Gegenkopplung der Transistorschaltung zu höheren Frequenzen hin erhöht werden. Wird der Transistor als Schalter betrieben - wie im NTL-Gatter - dann verkürzt das Parallelschalten eines Kondensators zum Emitterwiderstand die Schaltzeit.

Bei der Integration von Bauelementen auf einem Chip werden viele Bauelemente nicht diskret realisiert. Vielmehr nutzt man die Gesamtheit der Eigenschaften der auf das Halbleitersubstrat aufgebrachten Elemente. So dient beispielsweise der Widerstandsbeiwert der Leiterbahnen auf dem Chip zur Realisierung der für die jeweilige Schaltung notwendigen Widerstände und parasitäre Kapazitäten von Transistoren können bewußt als in der Schaltung ohnehin benötigte Kondensatoren eingesetzt werden. Selbst die Größe dieser Bauelemente, d. h. Widerstand und Kapazität, kann gezielt durch Variation der Länge und Breite von Leiterbahnen und Variation der Transistorfläche verändert werden. Der mit der veränderbaren, aber konstanten Versorgungsspannung angesteuerte MOS-Transistor ist deshalb so ausgestaltet, daß er zusätzlich zum erforderlichen Widerstandswert eine verhältnismäßig hohe Kapazität aufweist. Aufgrund dieser Maßnahme ist der Flächenbedarf dieses MOS-Transistors auf dem Chip groß. Um diesen Flächenbedarf zu verkleinern, wird zu einer Reihenschaltung eines mit der veränderbaren Versorgungsspannung angesteuerten MOS-Transistors mit einer ohmschen Last ein Bipolartransistor so parallel zugeschaltet, daß seine Basis am Koppelpunkt zwischen den Elementen der Reihenschaltung angeschlossen ist. Der so parallel geschaltete Bipolartransistor transformiert die Eigenschaften des nun eine wesentlich kleinere Fläche beanspruchenden MOS-Transistors derart, daß die so geschaffene Ersatzschaltung aus MOS-Transistor, ohmscher Last und Bipolartransistor den großflächig aufgebauten MOS-Transistor vollwertig ersetzt. Der Vorteil der Ersatzschaltunggegenüber dem großflächigen MOS-Transistor ist der kleinere Platzbedarf der Ersatzschaltung, wodurch eine größere Integrationsdichte erzielbar ist.

Besonders vorteilhaft kann das NTL-Gatter in Verbindung mit einem für ECL-Gatter typischen Schaltungsprizip verwendet werden. Häufig verwendet werden ECL-Gatter in Series-Gating-Schaltung zur Realisierung komplexerer Funktionen und für Flip-Flops. Mit Series-Gating bezeichnet man eine serielle logische Verknüpfung, bei der die Stromschalter übereinander angeordnet sind und gemeinsam aus einer Stromquelle gespeist werden. Ersetzt man die Stromquelle durch ein NTL-Gatter, dann schafft man damit die Möglichkeit, mittels einfacher logischer Ansteuerung der NTL-Schaltung mit in der ECL-Technik üblichen Logikpegeln wahlweise den gesamten Strom der übergeordneten ECL-Gatter abzuschalten und damit Leistung zu sparen. Durch konsequente Anwendung dieses Prinzips - und unter der Voraussetzung der Möglichkeit, die Schaltungsstrukturen zu verkleinern - kann die Packungsdichte und damit die Leistungsfähigkeit eines Halbleiterbausteins erhöht werden.

Anhand der Zeichnung wird im folgenden ein Ausführungsbeispiel näher erläutert. Dabei zeigen:

FIG 1    das Schaltbild eines bekannten NTL-NOT-Gatters,

FIG 2    die Übertragungskennlinien eines ECL-Gatters und eines NTL-Gatters,

FIG 3    ein Schaltbild eines erfindungsgemäß ausgebildeten NTL-NOT-Gatters,

FIG 4    die Übertragungskennlinie mit Andeutung der Wirkung von Spannungsänderungen an den Gate-Elektroden der MOS-Transistoren für das NTL-Gatter nach FIG 3,

FIG 5    ein gegenüber dem NTL-Gatter nach FIG 3 modifiziertes NTL-Gatter mit Grundlast und einem Ersatzschaltbild für den mit der veränderbaren Spannung angesteuerten MOS-Transistor,

FIG 6    ein Schaltbild eines NTL-NDR-Gatters mit Grundlaststrompfad für die MOS-Transistoren,

FIG 7    ein typisches Schaltbild eines AND/NAND-Gatters mit Series-Gating-Anordnung in ECL-Technik,

FIG 8    das ECL-Gatter nach FIG 7 modifiziert durch ein zusätzliches NTL-Gatter.

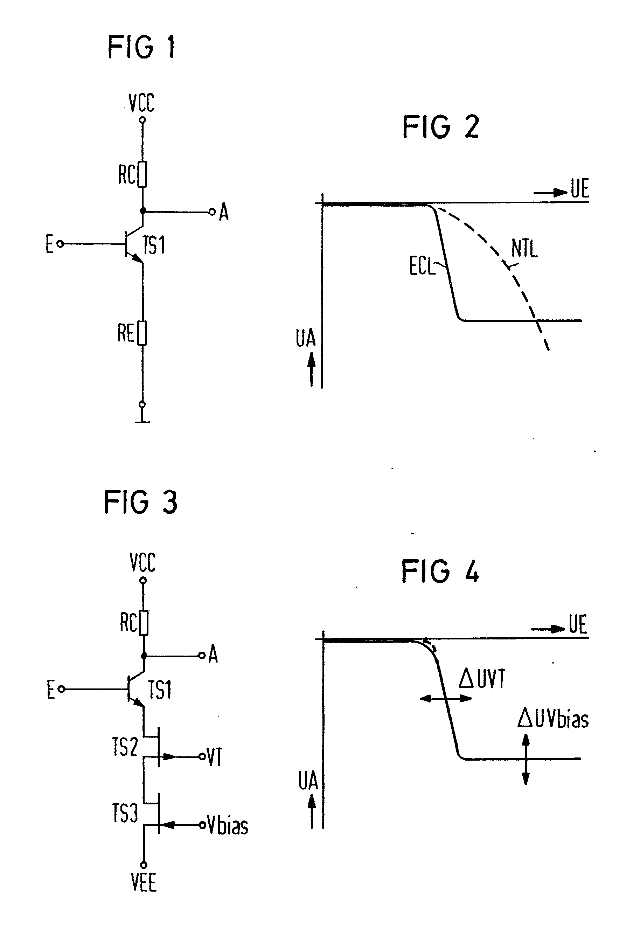

In FIG 1 ist ein NOT-Gatter in bekannter NTL-Technik dargestellt, mit dem sich Schaltzeiten im Subnanosekundenbereich ohne großen technologischen Aufwand erzielen lassen. Ein npn-Bipolartransistor TS1 in Emitterschaltung dient als Schaltelement. Der Kollektor des Transistors TS1, der auch den Gatterausgang A bildet, ist über einen Kollektorwiderstand RC an eine konstante Versorgungsspannung VCC angeschlossen. Die Basis des Transistors TS1 wird ohne zusätzliche Beschaltung unmittelbar als Gattereingang E verwendet, während der Emitter des Transistors TS1 über einen Emitterwiderstand RE an eine Versorgungsspannung, in vorliegendem Fall Bezugspotential, angeschlossen ist. Der Emitterwiderstand RE, dessen Widerstandswert etwa 0,5 bis 0,8 mal so groß ist wie der Wert des Kollektorwiderstandes RC, sorgt dafür, daß der npn-Bipolartransistor TS1 nicht in Sättigung gerät.

FIG 2 zeigt den Verlauf der Übertragungskennlinie, die jeweils mit Gattern der ECL- bzw. NTL-Technik erreichbar sind. Im Bereich niedriger Spannungswerte UE am Gattereingang E decken sich die beiden Kennlinien und zeigen einen flachen Verlauf. Bei einer Änderung der Eingangsspannung UE ändert sich die Ausgangsspannung UA also nicht. Dagegen zeigen sich zu größeren Eingangsspannungswerten UE hin gravierende Unterschiede der beiden Kennlinien. Während die Übertragungskennlinie des ECL-Gatters zunächst bei geringer Änderung der Eingangsspannung UE eine starke Änderung der Ausgangsspannung UA aufweist - also steil verläuft - und anschließend eine unabhängige von der Eingangsspannung UE über einen weiten Bereich nahezu konstante Ausgangsspannung UA aufweist, verläuft die Übertragungskennlinie des NTL-Gatters ab Erreichen einer Schaltschwelle vergleichsweise flach, und der Spannungswert der Ausgangsspannung UA bleibt bis zum Erreichen des zum jeweiligen Zeitpunkt vorliegenden Spannungswertes der Spannung eine Funktion der Eingangsspannung UE. Die Steilheit der Übertragungskennlinie des NTL-Gatters kann durch Variieren des Emitterwiderstandswertes RE und Verändern der Versorgungsspannung eingestellt werden.

In FIG 3 ist gegenüber dem Schaltbild aus FIG 1 der Emitterwiderstand RE durch eine Serienschaltung eines p-MOS und eines n-MOS-Feldeffekttransistors TS2, TS3 ersetzt. Am Gate des p-MOS-Feldeffekttransistors TS2 ist eine veränderbare, aber konstante Versorgungsspannung VT angeschlossen, während am Ende des Emitterstrompfades eine zweite konstante Versorgungsspannung VEE angeschaltet ist. Eine dritte konstante Spannung liegt am Gate des n-MOS-Feldeffekttransistors TS3.

Die Wirkung dieser Schaltungsänderung gegenüber FIG 1 zeigt FIG 4. Die Übertragungskennlinie des NTL-Gatters zeigt jetzt einen ähnlichen Verlauf wie die Übertragungskennlinie des ECL-Gatters.

Während dieser grundsätzliche Verlauf der durch Einsetzen der Serienschaltung von MOS-Transistoren TS2, TS3 anstelle des Emitterwiderstandes RE erhaltenen NTL-Übertragungskennlinie durch den geometrischen Aufbau der MOS-Transistoren auf dem Halbleiterchip - im Sinne der Festlegung des Gesamtwiderstandes der den Emitterwiderstand ersetzenden Bauelemente - eingestellt wird, wird die Feinabstimmung der Übertragungskennlinie durch Verändern der Gate-Spannungen UVT, UVbias vorgenommen. Eine Veränderung der Gate-Eingangsspannung UVbias am n-MOS-Transistor TS3 bewirkt bei leitender Kollektor-Emitterstrecke des Bipolartransistors TS1 eine Änderung der Ausgangsspannung UA des NTL-Gatters. Verändert man die Spannung UVT am Gate des p-MOS-Feldeffekttransistors TS2, so verschiebt man die Schaltschwelle des Gatters.

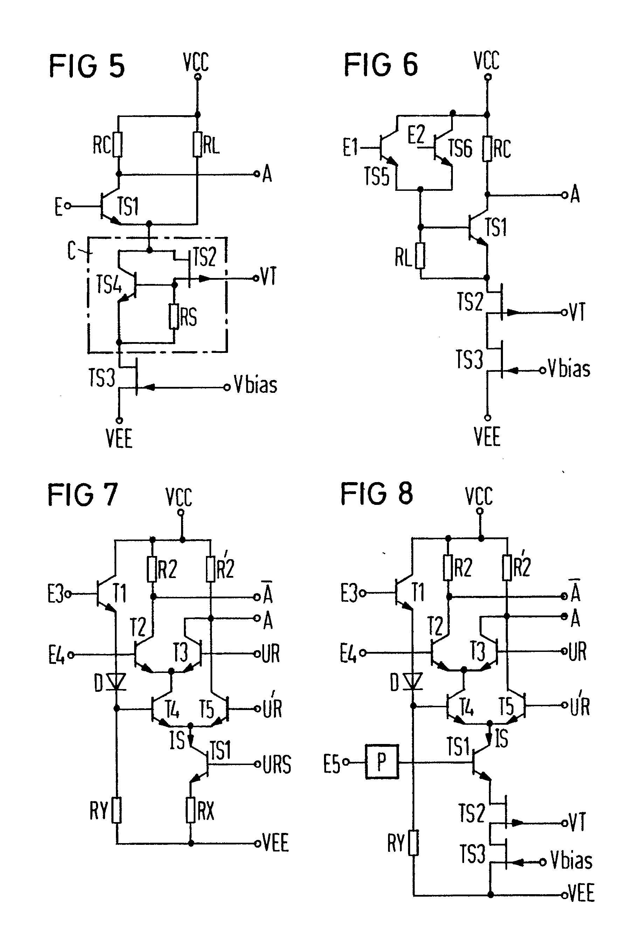

Der in Vollinie in FIG 4 gezeigte Verlauf der Übertragungskennlinie des NTL-Gatters weist den Mangel einer starken Verrundung bei Annäherung an die Schaltschwelle auf. Dieser Mangel kann durch Hinzufügen eines Lastwiderstandes RL zur Schaltung nach FIG 3, wie er in den Figuren 5 und 6 gezeigt ist, beseitigt werden.In FIG 5 befindet sich der Lastwiderstand RL zwischen der konstanten Versorgungsspannung VCC und dem Emitteranschluß des Bipolartransistors TS1. In FIG 6, die ein NOR-Gatter darstellt, ist der Lastwiderstand RL an der Basis und am Emitter des Bipolartransistors TS1 angeschlossen. Die Basis des Bipolartransistors TS1 dient dabei nicht unmittelbar als Gattereingang E. Die Gattereingänge E1, E2 werden vielmehr über - als Emitterfolger geschaltete - Bipolartransistoren TS5, TS6 zur Basis des Schalttransistors TS1 geführt. In beiden Fällen - FIG 5 und FIG 6 - fließt unabhängig vom Schaltzustand des Gatters ein permanenter Strom über den Lastwiderstand RL und die beiden MOS-Transistoren TS2, TS3. Damit ist sichergestellt, daß bei Vorliegen eines definierten Spannungspotentials an der Basis des Bipolarschalttransistors TS1 ohne Verzögerung in den anderen logischen Zustand am Ausgang A des Gatters umgeschaltet wird. Veranschaulicht wird die Wirkung des Lastwiderstandes RL in FIG 4. Ohne den Lastwiderstand RL weist die Übertragungskennlinie des Gatters den in Vollinie dargestellten Verlauf auf. Mit Lastwiderstand RL verändert sich der Verlauf der Übertragungskennlinie im Bereich des Wechsels von höheren Ausgangsspannungswerten UA zu kleineren Ausgangsspannungswerten UA in der mittels der gestrichelten Linie dargestellten Weise.

Der Ausschnitt C in FIG 5 zeigt eine Ersatzschaltung für den p-MOS-Feldeffekttransistor TS2 aus FIG 3. Zum p-MOS-Feldeffekttransistor TS2 ist ein ohmscher Widerstand RS in Reihe geschaltet; parallel zu dieser Reihenschaltung ist die Kollektor-Emitterstrecke eines Bipolartransistors TS4 angeschlossen, dessen Basisanschluß mit der Verbindungsstelle der in Reihe geschalteten Elemente verbunden ist. Diese Ersatzschaltung weist dieselben elektrischen Eigenschaften wie der p-MOS-Feldeffekttransistor TS2 aus FIG 3 auf, benötigt jedoch eine kleinere Fläche auf dem Halbleiterchip.

FIG 7 zeigt ein typisches ECL-NAND/AND-Gatter in Series-Gating-Schaltung. Zwei ECL-Gatter sind in Serie geschaltet. Die npn-Bipolartransistoren T2 und T3 bilden ein erstes Gatter und die npn-Bipolartransistoren T4, T5 bilden ein zweites Gatter. Die Emitter der Transistoren T2, T3 sind mit dem Kollektoranschluß des Transistors T4 zusammengeschaltet und die Emitter der Transistoren T4, T5 sind mit dem Kollektor eines npn-Bipolartransistors TS1, der als Konstantstromquelle dient, ebenfalls zusammengeschaltet. An die Basisanschlüsse der Transistoren T3, T5 und TS1 sind jeweils Referenzspannungen UR, UR' und URS angeschaltet, wobei mit den Referenzspannungen UR und UR' die Schaltschwelle des jeweiligen Gatters eingestellt wird und die Referenzspannung URS einen konstanten Strom IS im Kollektor-Emitterstrompfad des Transistors TS1 bewirkt. Der Kollektor des Transistors T2 dient als Gatter-Ausgang $\bar{A}$ und ist über einen Widerstand R2 an die konstante Versorgungsspannung VCC angeschlossen. Die Kollektoren der Transistoren T3, T5 dienen als Gatterausgang A und sind gemeinsam über einen Widerstand R2' ebenfalls zur konstanten Spannungsquelle VCC geführt. Der Emitter des Transistors TS1 ist über einen Widerstand RX mit der zweiten konstanten Versorgungsspannung VEE verbunden. Den Eingang E4 des Gatters bildet unmittelbar die Basis des Transistors T2, während die Basis des Transistors T4 mittelbar über eine Schaltungsanordnung zur Pegelanpassung als Eingang E3 des Gatters dient. Diese Schaltungsanordnung ist eine Serienschaltung eines mit seinem Kollektor an der konstanten Versorgungsspannung VCC angeschalteten npn-Bipolartransistors T1, dessen Basisanschluß als Eingang E3 dient, mit einer in Flußrichtung gepolten Diode D und einem Widerstand RY, der an die zweite konstante Versorgungsspannung VEE angeschlossen ist. Die Basis des Transistors T4 ist mit der Verbindungsstelle der Diode D mit dem Widerstand RY kontaktiert.

FIG 8 zeigt eine Series-Gating-Schaltung nach FIG 7, in der im Strompfad IS ein NTL-Gatter anstelle der Stromquelle eingefügt ist. Der Widerstand RX ist durch die in FIG 3 dargestellte Serienschaltung des p-Kanal-MOS-Feldeffekttransistors TS2 mit dem n-Kanal-MOS-Feldeffekttransistor TS3 ersetzt. Ebenso wie in FIG 3 wird der p-Kanal-Transistor mit der veränderbaren, aber konstanten Versorgungsspannung VT und der n-Kanal-Transistor mit der dritten konstanten Spannung Vbias an den Gateelektroden beaufschlagt. Der Transistor TS1 wird über eine schematisch dargestellte Pegelanpassungsschaltung P als dritter Gattereingang E5 genutzt. Der Strom IS wird von der dritten konstanten Spannung Vbias bestimmt. Wird das in FIG 8 dargestellte Gatter in einer komplexeren Schaltungsanordnung auf einem Halbleiterchip für eine bestimmte Zeit nicht benötigt, so kann es über den dritten Gattereingang E5 stromlos geschaltet werden.

**Patentansprüche**

1. Integrierbare Transistorschaltung der Logikfamilie NTL (Non Threshold Logic) aus mindestens je einem nicht in Sättigung betriebenen Bipolartransistor (TS1) mit Kollektor- und Emitterwiderstandsanordnung (RC, RE), bei der die Basis des Bipolartransistors (TS1) mit einem Signaleingang (E) und sein Kollektor mit einem Signalausgang (A) verbunden sind und die kollektorseitig von einer ersten konstanten Versorgungsspannung (VCC) gespeist wird, **dadurch gekennzeichnet,** daß die Emitterwiderstandsanordnung durch mindestens zwei in Serie geschaltete MOS-Transistoren (TS2, TS3) gebildet ist, daß diese Serienschaltung an einer zweiten konstanten Versorgungsspannung (VEE) angeschaltet ist, daß eine veränderbare Versorgungsspannung (VT) wenigstens an einen hochohmigen Gate-Anschluß eines der MOS-Transistoren (TS2) gelegt ist und daß eine dritte konstante Spannung (Vbias) ebenfalls wenigstens an einen hochohmigen Gate-Anschluß des jeweils anderen MOS-Transistors (TS3) angeschaltet ist.

2. Integrierbare Transistorschaltung nach Anspruch 1, **dadurch gekennzeichnet,** daß der von der veränderbaren Versorgungsspannung (VT) gesteuerte Transistor (TS2) vom p-Kanal-Typ und der von der dritten konstanten Versorgungsspannung (Vbias) gesteuerte Transistor (TS3) vom n-Kanal-Typ ist.

3. Integrierbare Transistorschaltung nach Anspruch 1 oder 2, **dadurch gekennzeichnet,** daß ein über die in Serie geschalteten MOS-Transistoren (TS2, TS3) verlaufender Grundlaststrompfad zwischen der ersten und der zweiten konstanten Versorgungsspannung (VEE, VCC) eingerichtet ist.

4. Integrierbare Transistorschaltung nach Anspruch 1 oder 2, **dadurch gekennzeichnet,** daß jeweils zu einer Reihenschaltung bestehend aus einem mit der veränderbaren Versorgungsspannung (VT) angesteuerten MOS-Transistor (TS2) und einem ohmschen Widerstand (RS) ein Bipolartransistor (TS4) so parallel geschaltet ist, daß seine Basis am Koppelpunkt zwischen den Elementen der Reihenschaltung angeschlossen ist.

5. Integrierbare Transistorschaltung nach Anspruch 1 oder 2, **dadurch gekennzeichnet,** daß diese Schaltung als eine den Strom mehrerer übergeordneter Schaltstufen vereinigende Schaltstufe in einer Series-Gating-Logik-Schaltung der ECL-Technik verwendet wird.

## FIG 1

## FIG 2

## FIG 3

## FIG 4

FIG 5

FIG 6

FIG 7

FIG 8

8